# EUROPÄISCHE PATENTANMELDUNG

(11) **EP 2 991 102 A1**
(43) Veröffentlichungstag der Anmeldung: **02.03.2016**
(21) Anmeldenummer: 15185644.0
(22) Anmeldetag: 19.08.2011
(51) Int. Cl.: H01L 21/228, H01L 21/02, C07F 9/50, H01L 31/18, C23C 18/12

(54) **P-DOTIERTE SILICIUMSCHICHTEN**

(30) Priorität: 03.09.2010 DE 102010040231
(62) Teilanmeldung aus: 11757199.2
(71) Anmelder: Evonik Degussa GmbH, 45145 Essen (DE)
(72) Erfinder: Wieber, Stephan, 76137 Karlsruhe (DE); Patz, Matthias, 46240 Bottrop (DE); Stüger, Harald, 8042 Graz (AT); Lehmkuhl, Jasmin, 45721 Haltern am See (DE)

(57) **Zusammenfassung**

Die Erfindung betrifft ein Verfahren zur Herstellung p-dotierter Siliciumschichten, insbesondere solcher Siliciumschichten, die aus flüssigen Silan-haltigen Formulierungen hergestellt werden. Die Erfindung betrifft ferner ein mit einer p-dotierten Siliciumschicht beschichtetes Substrat. Des Weiteren betrifft die Erfindung die Verwendung bestimmter Dotierungsmittel auf Basis von BorVerbindungen zur p-Dotierung einer Siliciumschicht.

## Beschreibung

Die Erfindung betrifft ein Verfahren zur Herstellung p-dotierter Siliciumschichten, insbesondere solcher Siliciumschichten, die aus flüssigen Silan-haltigen Formulierungen hergestellt werden. Die Erfindung betrifft ferner ein mit einer p-dotierten Siliciumschicht beschichtetes Substrat. Des Weiteren betrifft die Erfindung die Verwendung bestimmter Dotierungsmittel auf Basis von Bor-Verbindungen zur p-Dotierung einer Siliciumschicht.

Die Synthese von Siliciumschichten ist von großer Bedeutung für die Halbleiterindustrie, insbesondere für die Herstellung elektronischer oder optoelektronischer Bauteilschichten, z. B. für den Einsatz in Solarzellen, Photodioden und Transistoren.

Bei der Herstellung von Solarzellen benötigt man Halbleiterschichten unterschiedlicher Dotierung. Durch Abscheiden einer oder mehrerer Siliziumschichten auf einem geeigneten Substrat kann ein oder mehrere p-n Übergänge bzw. pin- oder nip-Übergänge erzeugt werden, die als Solarzelle wirken. Die Abscheidung erfolgt mittels einer für dünne Schichten geeigneten Auftragsvorrichtung, z. B. eines roll to roll coaters. Die entstandenen Schichten werden durch eine geeignete Temperaturbehandlung stabilisiert, so dass sie typischerweise eine Mischung von mikrokristallinen, nanokristallinen und amorphen Gefügen annehmen. Sofern nicht explizit ausgeführt, sollen hier alle mikrokristallinen, nanokristallinen und/oder amorphen Schichten allgemein als "konvertierte Si-Schichten" bezeichnet werden, da eine genaue Unterscheidung und Festlegung in den meisten Fällen nicht gut möglich ist bzw. für das erzielte Ergebnis von untergeordneter Bedeutung ist.

Dabei lassen sich p-dotierte Siliciumschichten prinzipiell über verschiedene Verfahren herstellen. Von diesen haben jedoch CVD Techniken den Nachteil, dass sie im Hochvakuum durchgeführt werden müssen. Verfahren basierend auf Gasphasenabscheidungen haben weiterhin den Nachteil, dass sie i) im Falle einer thermischen Reaktionsführung den Einsatz sehr hoher Temperaturen oder ii) im Falle des Einbringens der erforderlichen Energie für die Zersetzung des Precursors in Form von elektromagnetischer Strahlung hohe Energiedichten erfordern. In beiden Fällen ist es nur mit höchstem apparativem Aufwand möglich, die zur Zersetzung des Precursors benötigte Energie gezielt und einheitlich einzubringen. Da auch die anderen Verfahren zur Herstellung von p-dotierten Siliciumschichten nachteilig sind, werden somit p-dotierte Siliciumschichten bevorzugt über Abscheidungen aus der flüssigen Phase gebildet.

Bei derartigen Flüssigphasen-Verfahren zur Herstellung von p-dotierten Siliciumschichten werden flüssige Edukte oder Lösungen enthaltend feste oder flüssige Edukte, einen Dotierstoff, und ggf. weitere Additive, auf das zu beschichtende Substrat aufgebracht und nachfolgend thermisch und/oder mit elektromagnetischer Strahlung zu einer p-dotierten Siliciumschicht konvertiert.

Bevorzugt einsetzbare Edukte sind dabei Hydridosilane, sowie als Dotierstoffe Borverbindungen. Die Hydridosilane bestehen im Wesentlichen aus Silicium- und Wasserstoffatomen und haben den Vorteil, dass sie bei Konvertierung zu abgeschiedenem Silicium und gasförmigem Wasserstoff reagieren. Das abgeschiedene Silicium kann dabei noch einen für die elektronischen Eigenschaften förderlichen Rest-Wasserstoffanteil enthalten. Die Borverbindungen bestehen im Wesentlichen aus Boratomen und Kohlenwasserstoffresten bzw. Wasserstoffatomen.

Zum Stand der Technik gehören dabei vor allem Flüssigphasen-Verfahren zur Herstellung von p-dotierten Siliciumschichten aus flüssigen H-Silanen durch Zugabe von Hauptgruppe III Elementverbindungen bzw. aus heteroatomaren cyclischen Silanverbindungen des Typs SiₐX_{b}Y_{c}.

US 5,866,471 A beschreibt unter anderem den Einsatz linearer oder cyclischer Hydridosilane und silylgruppensubstituerter linearer oder cyclischer Hydridosilane, die thermisch in Anwesenheit eines Dotierstoffes in einen Halbleiterfilm des n-Typs bzw. p-Typs zersetzt werden können. Die genannten Stoffe sind bei Raumtemperatur fest, löslich in organischen Lösemitteln und weisen vorzugsweise einen Polymerisationsgrad von 3 bis 10.000, bevorzugt 5 bis 30 auf. Sie werden weiterhin bevorzugt zwischen 200 und 700 °C thermisch zersetzt, wobei die Härtungszeiten zwischen 10 Minuten und 10 Stunden liegen.

EP 1 085 579 A1 beschreibt Verfahren zur Herstellung von Solarzellen, bei denen flüssige Zusammensetzungen, die Silane enthalten, eingesetzt werden und mit Wärme, Licht und/oder Laserbehandlung konvertiert werden. Die flüssigen Beschichtungszusammensetzungen können ein Lösemittel und eine cyclische Siliciumverbindung der Formel SiₙXₘ (X = H, Hai, n ≥ 5, m = n, 2n-n, 2n) und/oder eine modifizierte Silanverbindung der Formel SiₐX_{b}Y_{c} (X = H, Hal, Y = B, P, a ≥ 3, c = 1 bis a und b = a bis 2a+c+2) enthalten. Die Umwandlung der flüssigen Zusammensetzungen in eine u.a. p-dotierte Si-Schicht kann über einen an einen Trocknungsschritt anschließenden Konvertierungsschritt erfolgen. Als typische Trocknungstemperatur wird ein Bereich von 100 bis 200 °C angegeben. Auch hier wird ausgeführt, dass erst ab 300 °C ein signifikanter Umsatz zu Siliciumschichten resultiert, dass zwischen 300 °C und 550 °C eine amorphe Schicht resultiert, und dass ab 550 °C polykristalline Schichten resultieren.

EP 1 357 154 A1 beschreibt Zusammensetzungen "höherer Silane", die ein Polysilan enthalten, das durch Bestrahlen eines photopolymerisierbaren Silans mit UV-Strahlung herstellbar ist. Bei dem photopolymerisierbaren Silan kann es sich um ein Silan der generischen Formel SiₙXₘ (mit n ≥ 3, m ≥ 4, X = H, Hal) handeln, beispielhaft genannte Verbindungen sind cyclische Silane der Formel SiₙX₂ₙ, bi- bzw. polycyclische Strukturen der Formel SiₙH₂ₙ₋₂ und andere Silane mit einer cyclischen Struktur im Molekül, die eine extreme hohe Reaktivität auf Licht zeigen und effizient photopolymerisieren. Die Zusammensetzungen des "höheren Silans" lassen sich auf einem Substrat durch thermische Zersetzung oder Photozersetzung in einen Siliciumfilm konvertieren. Dabei werden Hauptgruppe III bzw. V Elementverbindungen vor oder nach der Polymerisation eingesetzt. Dazu wird der feuchte Film durch Wärme (typischerweise 100 bis 200 °C) getrocknet und dann durch Wärme und/oder Licht konvertiert. Amorphe Filme lassen sich durch thermische Behandlung bei Temperaturen von kleiner als 550 ° erzeugen, bei höheren Temperaturen resultieren polykristalline Filme. In den Beispielen sind Konvertierungszeiten von 10 Minuten (350 °C, 400 °C, 500 °) aufgeführt und die Dotiersubstanzen PH₃, P₄, B₅H₉, B₁₀H₁₄. Nachteilig sind hier lange Konvertierungszeiten auf Grund stabiler Cluster sowie deren Toxizität. Auf Grund der sehr stabilen Boratomcluster ist eine homogene Verteilung des Bors erschwert, so dass ein relativ hoher Borzusatz notwendig ist (10 at% Bor).

EP 1640342 A1 beschreibt Zusammensetzungen "höherer Silane", die ein Polysilan enthalten, das laut GPC zwischen 800 und 5000 g/mol mittleres Molekulargewicht hat. Diese Zusammensetzung kann auch ein Element der 3. oder 5. Hauptgruppe enthalten. Im Beispiel wird Cyclopentasilan mit Decaboran bestrahlt. Der Film wird bei 400 °C für 30 min und anschließend bei 800 °C 5 min ausgehärtet. Nachteilig sind hier lange Konvertierungszeiten auf Grund stabiler Cluster sowie deren Toxizität. Auf Grund der sehr stabilen Boratomcluster ist eine homogene Verteilung des Bors erschwert.

US 2008022897 A1 beschreibt den Einsatz unterschiedlichster Dotierstoffe. In den Ansprüchen sind nur Zusammensetzungen beschrieben, jedoch keine Verfahrensbeschreibung, die zu n-bzw. p-Typ Si-Schichten führen. Anspruch 1 beschreibt die Zusammensetzung von SiₙH₂ₙ₊₂ mit n = 3 bis 20 und einem BR₃, in dem jedes R unabhängig H, Alkyl, etc. sein kann.

JP2002100576 A1 beschreibt den Einsatz eines BH₃-Sulfid-Komplexes als Dotierstoff. Dabei werden der Komplex, sowie das Hydridosilan pyrolysiert und auf einem Substrat durch ein geeignetes inertes organisches Medium in der Dampfphase gemeinsam abgeschieden. In den Beispielen werden Abscheidungstemperaturen von 400 °C und mindestens 20 min Konvertierungszeit angegeben.

All diesen beschriebenen Verfahren ist jedoch gemein, dass sie sehr lange Härtungszeiten benötigen, um die eingesetzten chemisch sehr stabilen Dotierstoffe in der Si-Schicht zu aktivieren.

Es ist somit Aufgabe der vorliegenden Erfindung, ein Verfahren zur Herstellung von p-dotierten Siliciumschichten bereitzustellen, das die angeführten Nachteile des Standes der Technik vermeidet. Insbesondere soll das Verfahren auf der Abscheidung von flüssigen Silan-Formulierungen basieren. Zudem soll ein Flüssigphasen-Verfahren zur Herstellung von p-dotierten Siliciumschichten bereitgestellt werden, bei dem die eingesetzten Formulierungen stabil sind, das Substrat gut benetzen, und das zu homogenen p-dotierten Siliciumschichten mit gleichmäßig verteilter Dotierung führt. Dabei wäre es weiterhin besonders vorteilhaft, p-dotierte aSi-Schichten mit guten Leitfähigkeiten herstellen zu können.

Die oben genannte Aufgabe wird erfindungsgemäß gelöst durch ein Verfahren zur Herstellung mindestens einer auf einem Substrat angeordneten p-dotierten Siliciumschicht umfassend die Schritte:
a) Bereitstellen eines Substrates,
b) Bereitstellen einer Formulierung enthaltend mindestens eine Silicium-Verbindung und, als Dotierungsmittel, mindestens eine Verbindung aus der Gruppe der Hydroborierungsmittel,
c) Aufbringen der Formulierung auf das Substrat,
d) Bestrahlen und/oder thermisches Behandeln des beschichteten Substrats, unter Bildung einer p-dotierten überwiegend aus Silicium bestehenden Schicht.

Unter Hydroborierungsmitteln im Sinne der vorliegenden Erfindung sind Bor-Verbindungen zu verstehen, die mindestens eine Bor-Wasserstoffbindung aufweisen, ausgenommen Diboran. Diboran wird im Rahmen der vorliegenden Erfindung von den geeigneten Hydroborierungsmitteln ausgenommen, da dieses aufgrund des gasförmigen Zustandes nachteilig ist. Zudem verläuft eine Reaktion mit Diboran als Hydroborierungsmittel sehr langsam. Vorzugsweise ist das Hydroborierungsmittel flüssig oder fest.

Die im erfindungsgemäßen Verfahren bevorzugt eingesetzte Verbindung aus der Gruppe der Hydroborierungsmittel ist ausgewählt aus a) einem BH₃-Komplex mit einem Komplexbildner ausgewählt aus der Gruppe bestehend aus THF; NR₃ mit R = H, Alkyl, Aryl sowie SR'₂ mit R' = H, Alkyl, Aryl; oder b) eine Verbindung des Typs BₓCₓₙH₂ₓₙ₋ₓ mit x = 1-4 und n = 3-10, herstellbar durch Reaktion eines BH₃-Komplexes wie unter a) definiert mit einem cyclischen Dien. Besonders bevorzugt aus der Gruppe a) und b) sind die Verbindungen BH₃*THF, BH₃*SMe₂, BH₃*NMe₃ bzw. 9-Borabicyclononan (9-BBN), 7-Borabicycloheptan und/oder 11-Borabicycloundecan. Ganz besonders bevorzugte Hydroborierungsmittel sind BH₃*THF, BH₃*NMe₃ und 9-Borabicyclononan (9-BBN).

Unter einer Formulierung "enthaltend mindestens eine Silicium-Verbindung und mindestens eine Verbindung aus der Gruppe der Hydroborierungsmittel" ist dabei im Sinne dieser Erfindung sowohl eine aus mindestens einer Silicium-Verbindung und mindestens einer Verbindung aus der genannten Gruppe der Hydroborierungsmittel bestehende Zusammensetzung als auch eine aus mindestens einer Silicium-Verbindung und mindestens einer Verbindung aus der Gruppe der Hydroborierungsmittel herstellbare Zusammensetzung, insbesondere eine ein Umsetzungsprodukt mindestens einer Siliciumverbindung mit mindestens einer Verbindung aus der genannten Gruppe der Hydroborierungsmittel zu verstehen.

Die zuvor unter a) und b) genannte Klasse von Dotierstoffen wurde bisher in der organischen Synthesechemie insbesondere für die Hydroborierung von Alkenen eingesetzt, um bei der anschließenden Hydroxylierung das entsprechende Anti-Markovnikov-Produkt zur erhalten. Deshalb ist insbesondere überraschend, dass diese Klasse von Verbindungen für die Dotierung von Si-Schichten für optoelektronische Bauteile Verwendung finden kann. Sie sind kommerziell erhältlich und lagerstabil. In den meisten Fällen sind sie nicht giftig und zeigen keine Clusterbildung, die eine homogene Verteilung des Dotieratoms in der Si-Schicht erschwert.

Das erfindungsgemäße Verfahren bietet mehrere Vorteile. So können in Schritt d) kürzere Zeiten erzielt werden, die zu den dotierten p-Schichten führen. Das dürfte daran liegen, dass das Dotierelement leichter freigesetzt wird als aus Verbindungen, die im Stand der Technik verwendet werden. Auch ist der bei der Abgabe des Dotierelements entstehende Rest stabil und gut verdampfbar. Weiterer Vorteil ist, dass nicht-giftige kommerziell erhältliche Substanzen verwendet werden können. Überraschenderweise werden mit der neuen Klasse von Dotierstoffen darüber hinaus p-dotierte Siliciumschichten mit sehr guter Leitfähigkeit zugänglich.

Die im erfindungsgemäßen Verfahren bevorzugt eingesetzte Silicium-Verbindung ist eine Silicium-Wasserstoff-Verbindung, vorzugsweise der allgemeinen Formel SiₙH₂ₙ₊₂ oder SiₙH₂ₙ mit n= 3 bis 20; ein Silicium-Halogenid; ein Silicium-Organyl; eine oligomere Silicium-Verbindung SiₙR₂ₙ₊₂ oder SiₙR₂ₙ mit jeweils n= 8 bis 100 und R= H, Halogen, Organyl, wobei jedes R unabhängig gewählt sein kann; oder eine beliebige Mischung solcher Silicium-Verbindungen. Des Weiteren können die genannten Verbindungen, insbesondere die Silicium-Wasserstoff-Verbindungen der allgemeinen Formel SiₙH₂ₙ₊₂ oder SiₙH₂ₙ mit n= 3 bis 20, bevor sie in Schritt b) verwendet werden, teilweise oder in Gänze oligomerisiert werden, wobei Molmassen von 330 g/mol bis 10000 g/mol, bevorzugt 400 g/mol bis 3000 g/mol, besonders bevorzugt 500 g/mol bis 1000 g/mol, eingestellt werden können. Die Oligomerisierung kann dabei, teilweise oder in Gänze, durch Bestrahlen oder thermische Behandlung erfolgen.

Besonders bevorzugt werden Silicium-Wasserstoff-Verbindungen, also Silane und Oligo- bzw. Polysilane, eingesetzt, da diese durch chemische Synthesen oder katalytische Anellierung von SiH₄ zugänglich sind und einen hohen Silicium-Anteil bezogen auf das Molgewicht der Verbindungen aufweisen. Von den Silanen eignen sich besonders solche der allgemeinen Formel SiₙH₂ₙ₊₂ mit n = 3 bis 10, bevorzugt n = 4 bis 8, oder SiₙH₂ₙ mit n= 4 bis 8, bevorzugt n = 5 und 6, für das erfindungsgemäße Verfahren.

Die oligomere Silicium-Verbindung SiₙR₂ₙ₊₂ oder SiₙR₂ₙ mit n= 8 bis 100 und R= H kann zum Beispiel durch Oligomerisierung einer oder mehrerer Silicium-Verbindungen der allgemeinen Formel SiₙH₂ₙ₊₂ oder SiₙH₂ₙ mit n= 3 bis 20 hergestellt werden. Die oligomere Silicium-Verbindung SiₙR₂ₙ₊₂ oder SiₙR₂ₙ mit jeweils n= 8 bis 100 und R= Halogen kann zum Beispiel durch Oligomerisierung einer oder mehrerer Silicium-Halogenide hergestellt werden. Schließlich kann die oligomere Silicium-Verbindung SiₙR₂ₙ₊₂ oder SiₙR₂ₙ mit jeweils n= 8 bis 100 und R= Organyl durch Oligomerisierung einer oder mehrerer Silicium-Organyle hergestellt werden. In allen Fällen kann jedes oben genannte R unabhängig gewählt sein.

In einer Variante des erfindungsgemäßen Verfahrens kann die Silicium-haltige Formulierung durch Oligomerisieren und/oder Polymerisieren eines Gemisches enthaltend mindestens ein höheres Silan der allgemeinen Formel SiₙH₂ₙ₊₂ mit n = 3 bis 10, bevorzugt n = 4 bis 8, oder SiₙH₂ₙ mit n= 4 bis 8, bevorzugt n = 5 und 6 hergestellt werden. Zur Oligomerisierung mittels UV-Bestrahlung oder Wärmebehandlung werden höhere Silane der vorgenannten Formeln mit n ≥ 3 eingesetzt. Auf diese Weise kann aus einer flüssigen niedrigviskosen Mischung in einem Schritt eine gewünschte höherviskose Flüssigmischung enthaltend Oligo-/Polysilane hergestellt werden.

In einer weiteren Variante des erfindungsgemäßen Verfahrens kann die Silicium-haltige Formulierung durch Oligomerisieren und/oder Polymerisieren eines Gemisches enthaltend mindestens eine Silicium-haltige Verbindung und mindestens einen Dotierstoff aus der Gruppe der Hydroborierungsreagenzien mittels eines energetischen Prozesses z. B. UV-Bestrahlung, thermische Behandlung hergestellt werden (Co-Oligomerisierung). Die Zugabe der Verbindung aus der Gruppe der Hydroborierungsmittel kann somit vor oder nach oder auch während einer gegebenenfalls vorgenommenen Oligomerisierung und/oder Polymerisierung der Silicium-haltigen Verbindung erfolgen.

Die in den erfindungsgemäßen Verfahren verwendete Silicium-haltige Formulierung ist typischerweise eine flüssige Formulierung. Diese besteht aus den vorgenannten Silicium-Verbindungen und gegebenenfalls im Gemisch mit Lösungsmitteln. Bevorzugt einsetzbar sind Lösemittel aus der Gruppe bestehend aus linearen, verzweigten oder cyclischen gesättigten, ungesättigten oder aromatischen Kohlenwasserstoffen mit einem bis 12 Kohlenstoffatomen (ggf. partiell oder vollständig halogeniert), Alkoholen, Ethern, Carbonsäuren, Estern, Nitrilen, Aminen, Amiden, Sulfoxiden und Wasser. Besonders bevorzugt sind n-Pentan, n-Hexan, n-Heptan, n-Oktan, n-Dekan, Dodekan, Cyclohexan, Cyclooctan, Cyclodekan, Dicyclopentan, Benzol, Toluol, m-Xylol, p-Xylol, Mesitylen, Indan, Inden, Tetrahydronaphtalin, Decahydronaphtalin, Diethylether, Dipropylether, Ethylenglycoldimethylether, Ethylenglycoldiethylether, Ethylenglycolmethylethylether, Diethylenglycoldimethylether, Diethylenglycoldiethylether, Diethylenglycolmethylethylether, Tetrahydrofuran, p-Dioxan, Acetonitril, Dimethylformamid, Dimethylsulfoxid, Dichlormethan und Chloroform.

Besonders gut einsetzbare Lösemittel sind die Kohlenwasserstoffe n-Pentan, n-Hexan, n-Heptan, n-Oktan, n-Dekan, Dodekan, Cyclohexan, Cyclooctan, Cyclodekan, Benzol, Toluol, m-Xylol, p-Xylol, Mesitylen, Indan und Inden.

Gegebenenfalls kann/können zusätzlich weitere Lösungsmittel, weitere Dotierungsmittel und/oder weitere Hilfsstoffe zugesetzt werden. Dabei können diese weiteren Mittel bzw. Stoffe unabhängig voneinander dem Gemisch bereits vor dem Oligomerisieren und/oder Polymerisieren oder erst danach zugesetzt werden. Auch in diesem Fall kann das Oligomerisieren und/oder Polymerisieren teilweise oder in Gänze durch Bestrahlen oder thermische Behandlung erfolgen, wobei Molmassen von 330 g/mol bis 10000 g/mol, bevorzugt 400 g/mol bis 3000 g/mol, besonders bevorzugt 500 g/mol bis 1000 g/mol, eingestellt werden können. Der Anteil an Lösungsmittel bezogen auf die Gesamtformulierung kann 5 bis 99 Gew.%, bevorzugt 25 bis 85 Gew.-%, besonders bevorzugt 50 bis 85 Gew.-% betragen.

Das Beschichten des Substrats mit der Silicium-haltigen Formulierung kann auf bekannte Weise erfolgen. Bevorzugt wird die Formulierung über ein Verfahren abgeschieden ausgewählt aus Druck- bzw. Beschichtungsverfahren (insbesondere Flexo/Gravur-Druck, Inkjet-Druck, Offset-Druck, digitalem Offset-Druck und Siebdruck), Sprühverfahren, Rotationsbeschichtungsverfahren ("Spin-coating"), Tauchverfahren ("Dip-coating") und Verfahren ausgewählt aus Meniscus Coating, Slit Coating, Slot-Die Coating, und Curtain Coating.

Das thermische Behandeln des beschichteten Substrats kann auf bekannte Weise erfolgen, insbesondere unter weitgehendem Ausschluss von O₂ und H₂O. So kann etwa das mit der Formulierung beschichtete Substrat auf Temperaturen von 200 bis 1000 °C, vorzugsweise 250 bis 700 °C, weiter bevorzugt 300 bis 650 °C, erhitzt werden. Dabei bildet sich erfindungsgemäß eine zumindest teilweise konvertierte und überwiegend aus Silicium bestehende Schicht. Im Falle frisch hergestellter Schichten kann auch mit einer UV-Lampe (z. B. Wellenlänge 254 nm oder Wellenlänge 180 nm) eine vorgeschaltete Härtung durch Vernetzung erfolgen. In einer bevorzugten Ausführungsform des erfindungsgemäßen Verfahrens wird das beschichtete Substrat ohne Bestrahlung einer thermischen Behandlung zugeführt. Prinzipiell kann die Temperierung durch den Einsatz von Öfen, beheizten Walzen, Heizplatten, Infrarot- oder Mikrowellenstrahlung oder ähnlichem erfolgen. Besonders bevorzugt wird die Temperierung jedoch wegen des dann resultierenden geringen Aufwandes mit einer Heizplatte oder mit beheizten Walzen im Rolle-zu-Rolle-Verfahren durchgeführt.

Die Temperaturen reichen von 200°C bis 1000°C. Die Schichten können auch nachbehandelt werden durch Erhitzen unter Formiergas-Mischungen aus Wasserstoff und Stickstoff oder aus Wasserstoff und Argon (z. B. H₂/N₂ im Volumen-Verhältnis 5/95 bis 10/90 oder H₂/Ar im Volumen-Verhältnis 5/95 bis 10/90) bei Temperaturen von 250°C bis 700°C, bevorzugt 300°C bis 650°C.

Beim thermischen Behandeln des beschichteten Substrats erfolgt die Konvertierung des zumindest teilweise oligomerisierten und überwiegend aus Silicium bestehenden Films in der Regel innerhalb von weniger als 10 Minuten, bevorzugt weniger als 5 Minuten. Die Konvertierung kann unter Drücken von 200 mbar bis zu 50 bar stattfinden. Vorzugsweise findet die Konvertierung bei Drücken von 500 mbar bis 10 bar statt, ganz besonders bevorzugt zwischen 800 mbar und 1300 mbar. Die Temperaturen können dabei zwischen 250 °C und 700 °C liegen, vorzugsweise liegen sie zwischen 300 °C und 650 °C für p-dotierte aSi-Schichten. Die Konvertierung kann in einem oder mehreren aufeinanderfolgenden Temperaturschritten stattfinden.

Durch längere Konvertierungszeiten verlieren die entstehenden Schichten mehr Wasserstoff, welcher Fehlstellen, sogenannte dangling bonds, absättigt. Diese Fehlstellen können Fallen für die Dotierladungsträger darstellen und damit schlechtere Dotiereffizienzen hervorrufen. Längere Konvertierungszeiten wie sie im Stand der Technik beschrieben werden sind zudem nachteilig, da dadurch höhere Prozesskosten durch längere Beschichtungsstraßen entstehen.

Wie oben erwähnt, ist das erfindungsgemäße Verfahren geeignet zur Herstellung "mindestens einer" auf einem Substrat angeordneten Siliziumschicht. Um mehrere entsprechende Siliziumschichten auf einem Substrat zu erhalten können die Verfahrensschritte (b) bis (d) mehrfach durchgeführt werden. Bei mehreren Durchgängen der Verfahrensschritte können die einzelnen Schritte unabhängig voneinander konkret ausgestaltet werden, so dass die Eigenschaften jeder Schicht individuell für den beabsichtigten Zweck eingestellt werden können.

Für das erfindungsgemäße Verfahren können eine Vielzahl von Substraten eingesetzt werden. Bevorzugt sind Substrate bestehend aus Glas, Quarzglas, Graphit, Metall, Silicium oder bestehend aus einer auf einem hitzeverträglichen Träger befindliche Silicium-, Indiumzinnoxid-, ZnO:F- oder SnO₂:F-Schicht.

Bevorzugte Metalle sind Aluminium, Edelstahl, Cr-Stahl, Titan, Chrom bzw. Molybdän. Ferner können Kunststofffolien z. B. aus PEN, PET oder Polyimiden eingesetzt werden.

Als Substrat kann aber auch ein beschichtetes Substrat eingesetzt werden, welches bereits nach dem hier beschriebenen Verfahren hergestellt wurde.

Gegenstand der vorliegenden Erfindung ist auch ein beschichtetes Substrat umfassend ein Substrat und eine p-dotierte Siliciumschicht, dadurch gekennzeichnet, dass die p-Dotierung eine Bor-Dotierung ist, wobei das Bor durch eine Verbindung aus der Gruppe der Hydroborierungsmittel, wie oben beschrieben, eingebracht wurde.

Die oben genannten beschichteten Substrate können vorzugsweise nach dem hier beschriebenen erfindungsgemäßen Verfahren hergestellt werden.

Als Substrate kommen alle oben genannten Materialien und Anordnungen in Frage, insbesondere solche, die elektrisch leitfähig sind oder die eine elektrisch leitfähige Oberfläche aufweisen.

Ein weiterer Gegenstand der vorliegenden Erfindung ist ein photovoltaisches Gerät, insbesondere eine Solarzelle oder Solarzellenkombinationen, welches unter Anwendung des hier beschriebenen erfindungsgemäßen Verfahrens oder seiner Varianten hergestellt wurde bzw. hergestellt werden kann.

Die vorliegende Erfindung umfasst insbesondere auch die Verwendung einer Verbindung aus der Gruppe der Hydroborierungsmittel zur p-Dotierung einer Siliciumschicht. Und zwar solcher Siliciumschichten, die hergestellt werden durch ein Verfahren umfassend die Schritte Aufbringen einer Formulierung enthaltend mindestens eine Silicium-Verbindung und Bestrahlen und/oder thermisches Behandeln des beschichteten Substrats unter Bildung einer p-dotierten überwiegend aus Silicium bestehenden Schicht.

### Beispiele:

Die angegebenen Schichtdicken wurden mit einem Ellipsometer SENpro, Firma Sentech, Berlin gemessen. Die angegebenen elektrischen Messungen wurden in einer Glove-Box mit einer N₂ - Atmosphäre, die eine Sauerstoffkonzentration unter 1 ppm und einen Wassergehalt von höchstens 1 ppm aufwies, mit einem Keithley Gerät durchgeführt.

### Beispiel 1: Herstellung einer mit einem Hydroborierungsmittel (BH₃*THF) p-dotierten Si-Schicht

In einer Glove-Box mit einer N₂-Atmosphäre, die eine Sauerstoffkonzentration unter 1 ppm und einen Wassergehalt von höchstens 1 ppm aufweist, werden 3 mL Cyclopentasilan mit 3 mL Toluol und 0,5 mL BH₃*THF Komplex versetzt und im offenen Gefäß mit einer UV-Lampe der Wellenlänge 254 nm für eine Zeitdauer von 150 min bestrahlt. Dabei wird das dünnflüssige Silan dickflüssiger (Formulierung 1)

Vier Tropfen der Formulierung 2 aus 0,2 mL von Formulierung 1 und 0,9 mL Cyclooctan werden auf ein Glasplättchen der Größe 2,5 cm x 2,5 cm aufgebracht und mit Hilfe eines Spincoaters bei 6000 U/min gleichmäßig auf dem Glasplättchen verteilt. Anschließend wird mit Hilfe einer Heizplatte der Film bei 500 °C für die Dauer von 1 min erhitzt. Es entsteht eine dunkle, im Wesentlichen sauerstofffreie p-dotierte Silicium-Schicht auf dem Substrat. Die Schichtdicke beträgt 134 nm. Leitfähigkeitsmessungen ergeben einen spez. Dunkelwiderstand von 2 x 10E+05 Ohmcm.

### Beispiel 2: Herstellung einer mit 9-Borabicyclononan p-dotierten Si-Schicht

In einer Glove-Box mit einer N₂-Atmosphäre, die eine Sauerstoffkonzentration unter 1 ppm und einen Wassergehalt von höchstens 1 ppm aufweist, werden 4 mL Cyclopentasilan mit 4 mL Cyclooctan versetzt und im offenen Gefäß mit einer UV-Lampe der Wellenlänge 254 nm für eine Zeitdauer von 160 min bestrahlt. Dabei wird das dünnflüssige Silan dickflüssiger (Fomulierung 3)

Vier Tropfen der Formulierung 4 aus 0,075 mL von Formulierung 3, 0,141 mL Cyclooctan, 0,103 mL Toluol und 0,056 mL Cyclopentasilan werden mit 9 mg 9-BBN versetzt und werden auf ein Glasplättchen der Größe 2,5 cm x 2,5 cm aufgebracht und mit Hilfe eines Spincoaters bei 3000 U/min gleichmäßig auf dem Glasplättchen verteilt. Anschließend wird mit Hilfe einer Heizplatte der Film bei 500 °C für die Dauer von 1 min erhitzt. Es entsteht eine dunkle, im Wesentlichen sauerstofffreie p-dotierte Silicium-Schicht auf dem Substrat. Die Schichtdicke beträgt 149 nm. Leitfähigkeitsmessungen ergeben einen spez. Dunkelwiderstand von ca. 7 x 10E+04 Ohmcm.

### Beispiel 3 (Vergleich): Herstellung einer mit Decaboran p-dotierten Si-Schicht

In einer Glove-Box mit einer N₂-Atmosphäre, die eine Sauerstoffkonzentration unter 1 ppm und einen Wassergehalt von höchstens 1 ppm aufweist, werden 1,7 g einer 1:1 Mischung Cyclopentasilan in Toluol mit 0,05 g Decaboran versetzt und im offenen Gefäß mit einer UV-Lampe der Wellenlänge 254 nm für eine Zeitdauer von 90 min bestrahlt. Dabei wird das dünnflüssige Silan dickflüssiger (Formulierung 5). Weiterhin werden 2,5 mL Cyclopentasilan alleine für 55 min. bestrahlt. Dabei oligomerisiert das Cyclopentasilan zu einem dickflüssigen Oligomer. 0,2 mL dieses dickflüssigen Oligomers werden mit 0,05 mL von Formulierung 5 und 0,5 mL Toluol gemischt (Formulierung 6).

Vier Tropfen der Formulierung 6 werden auf ein Glasplättchen der Größe 2,5 cm x 2,5 cm aufgebracht und mit Hilfe eines Spincoaters bei 3000 U/min gleichmäßig auf dem Glasplättchen verteilt. Anschließend wird mit Hilfe einer Heizplatte der Film bei 500 °C für die Dauer von 1 min erhitzt. Es entsteht eine dunkle, im Wesentlichen sauerstofffreie p-dotierte Silicium-Schicht auf dem Substrat. Die Schichtdicke beträgt 173 nm. Leitfähigkeitsmessungen ergeben einen spez. Dunkelwiderstand von 2,6 x 10E+09 Ohmcm.

## Patentansprüche

1. Beschichtetes Substrat umfassend ein Substrat und eine p-dotierte Siliciumschicht, **dadurch gekennzeichnet, dass** die p-Dotierung eine Bor-Dotierung ist, wobei das Bor durch eine Verbindung aus der Gruppe der BH₃-Komplexe mit einem Komplexbildner ausgewählt aus der Gruppe bestehend aus THF; NR₃ mit R = H, Alkyl, Aryl sowie SR'₂ mit R' = H, Alkyl, Aryl eingebracht wird.

2. Beschichtetes Substrat nach Anspruch 1, hergestellt nach einem Verfahren zur Herstellung mindestens einer auf einem Substrat angeordneten p-dotierten Siliciumschicht umfassend die Schritte:
(a) Bereitstellen eines Substrates,
(b) Bereitstellen einer Formulierung enthaltend mindestens eine Silicium-Verbindung und, als Dotierungsmittel, mindestens einen BH₃-Komplex mit einem Komplexbildner ausgewählt aus der Gruppe bestehend aus THF; NR₃ mit R = H, Alkyl, Aryl sowie SR'₂ mit R' = H, Alkyl, Aryl,
(c) Aufbringen der Formulierung auf das Substrat,
(d) Bestrahlen und/oder thermisches Behandeln des beschichteten Substrats, unter Bildung einer p-dotierten überwiegend aus Silicium bestehenden Schicht.

3. Beschichtetes Substrat nach Anspruch 1 oder 2, wobei das Substrat elektrisch leitfähig ist oder eine elektrisch leitfähige Oberfläche aufweist.

4. Photovoltaisches Gerät, insbesondere Solarzelle oder Kombination von Solarzellen, wobei das photovoltaische Gerät ein beschichtetes Substrat nach einem der Ansprüche 1 bis 2 umfasst.
